(19) Europäisches Patentamt

European Patent Office

Office européen des brevets

(11) **EP 2 137 726 B1**

(12) **EUROPEAN PATENT SPECIFICATION**

(45) Date of publication and mention
of the grant of the patent:
**28.09.2011 Bulletin 2011/39**

(21) Application number: **08723355.7**

(22) Date of filing: **07.03.2008**

(51) Int Cl.:
*G10L 19/04* (2006.01)          *H04S 7/00* (2006.01)
*G10L 19/00* (2006.01)          *G10L 19/14* (2006.01)

(86) International application number:
**PCT/KR2008/001318**

(87) International publication number:
**WO 2008/111773 (18.09.2008 Gazette 2008/38)**

(54) **A METHOD AND AN APPARATUS FOR PROCESSING AN AUDIO SIGNAL**

VERFAHREN UND VORRICHTUNG ZUM VERARBEITEN EINES AUDIOSIGNALS

PROCÉDÉ ET APPAREIL DE TRAITEMENT DE SIGNAL AUDIO

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **09.03.2007 US 894162 P
08.06.2007 US 942967 P
06.12.2007 US 12022
07.03.2008 KR 20080021381**

(43) Date of publication of application:
**30.12.2009 Bulletin 2009/53**

(73) Proprietor: **LG Electronics Inc.
Seoul 137-724 (KR)**

(72) Inventors:
• **OH, Hyen O
Seoul 137-724 (KR)**
• **JUNG, Yang Won
Seoul 137-724 (KR)**

(74) Representative: **Katérle, Axel
Wuesthoff & Wuesthoff
Patent- und Rechtsanwälte
Schweigerstraße 2
81541 München (DE)**

(56) References cited:
EP-A1- 1 691 348          WO-A1-2006/072270
WO-A1-2007/027051          WO-A1-2008/046531
WO-A2-2006/126844

• **MYBURG F. ET AL.: 'The reference model
architecture for MPEG spatial audio coding'
CONVENTION PAPER 6447, 118TH CONVENTION
AUDIO ENGINEERING SOCIETY, BARCELONA,
SPAIN 28 May 2005 - 31 May 2005, XP009059973**
• **KOPPENS J. ET AL.: 'Multi-channel goes mobile:
MPEG surround binaural rendering' AES 29TH
INTERNATIONAL CONFERENCE PAPER, SEOUL
KOREA 02 September 2006 - 04 September 2006,
XP007902577**
• **OOMEN W. ET AL.: 'MPEG spatial audio coding/
MPEG surround: overview and current status'
CONVENTION PAPER, 119TH CONVENTION
AUDIO ENGINEERING SOCIETY, NEW YORK
USA 07 October 2005 - 10 October 2005,
XP002379094**

**Description**

The present invention relates to a method and an apparatus for processing an audio signal, and more particularly, to an audio signal processing method and apparatus particularly suitable for processing an audio signal received via one of a digital medium, a broadcast signal and the like.

Generally, in processing an object based audio signal, a single object constituting an input signal is processed as an independent object. In this case, since correlation may exist between objects, efficient coding is possible in case of performing coding using the correlation.

WO 2008/046531 A1 being prior art under Article 54(3) EPC may be construed to disclose a method (and a related apparatus) comprising receiving a downmix signal including at least one object, and a bitstream including object information, and obtaining correlation information relating to an object. The correlation information takes the form of a correlation matrix that renders a given number of objects to another given number of audio channels.

Accordingly, the present invention is directed to enhance processing efficiency of audio signal.

An object of the present invention is to provide a method of processing a signal using correlation information between objects in processing an object based audio signal.

Another object of the present invention is to provide a method of grouping correlated objects.

Another object of the present invention is to provide a method of obtaining information indicating correlation between grouped objects.

Another object of the present invention is to provide a method of transmitting meta information on an object.

Accordingly, the present invention provides the following effects or advantages.

First of all, in case of object signals having close correlation in-between, it is able to enhance audio signal processing efficiency by providing a method of grouping them into a group. Secondly, it is able to further enhance efficiency by transmitting the same information on the grouped objects. Thirdly, by transmitting detailed attribute information on each object, it is able to control a user-specific object directly and in detail.

DESCRIPTION OF DRAWINGS

The accompanying drawings, which are included to provide a further understanding of the invention and are incorporated in and constitute a part of this specification, illustrate embodiments of the invention and together with the description serve to explain the principles of the invention.

In the drawings:

FIG. 1 is a diagram of an audio signal processing apparatus according to an embodiment of the present invention;
FIG. 2 is a diagram of a method of transmitting meta information on an object according to an embodiment of the present invention;
FIGs. 3 to 5 are diagrams of syntax for a method of obtaining information indicating correlation of grouped objects according to an embodiment of the present invention; and
FIG. 6 is a structural diagram of a bit stream containing meta information on object according to an embodiment of the present invention.

Additional features and advantages of the invention will be set forth in the description which follows, and in part will be apparent from the description, or may be learned by practice of the invention. The objectives and other advantages of the invention will be realized and attained by the structure particularly pointed out in the written description and claims thereof as well as the appended drawings.

There are provided a method according to claim 1, a computer-readable medium according to claim 12 and an apparatus according to claim 13. Developments are set out in the dependent claims.

Reference will now be made in detail to the preferred embodiments of the present invention, examples of which are illustrated in the accompanying drawings. This does not put limitation of the technical idea, core configuration and operation of the present invention.

Moreover, terminologies used currently and widely are selected as terminologies used in this disclosure of the present invention. In some cases, terminologies arbitrarily selected by the applicant are used for the description of the present invention. For this, the accurate or correct meanings are specified in detailed description of the corresponding part. Therefore, it is understood that the arbitrarily selected terminology is not only simply construed as the name of the terminology used in this disclosure but also construed as the meaning of the corresponding terminology.

In particular, information in this disclosure is the terminology relating to values, parameters, coefficients, elements and the like and may be construed as different meanings, which does not put limitation on the present invention.

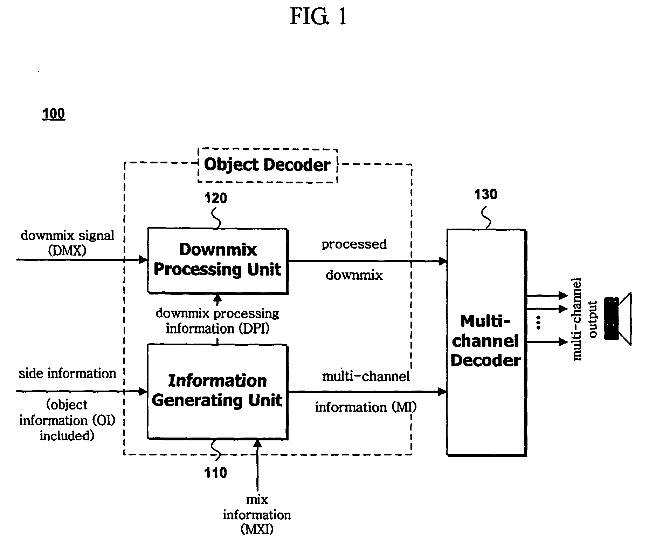

FIG. 1 is a diagram of an audio signal processing apparatus according to an embodiment of the present invention.

Referring to FIG. 1, an audio signal processing apparatus 100 according to an embodiment of the present invention includes an information generating unit 110, a downmix processing unit 120, and a multi-channel decoder 130.

The information generating unit 110 receives side information containing object information (OI) and the lie via an audio signal bit stream and receives mix information (MXI) via user interface. In this case, the object information (OI) is the information about objects contained within a downmix signal and may include object level information, object correlation information, meta information and the like.

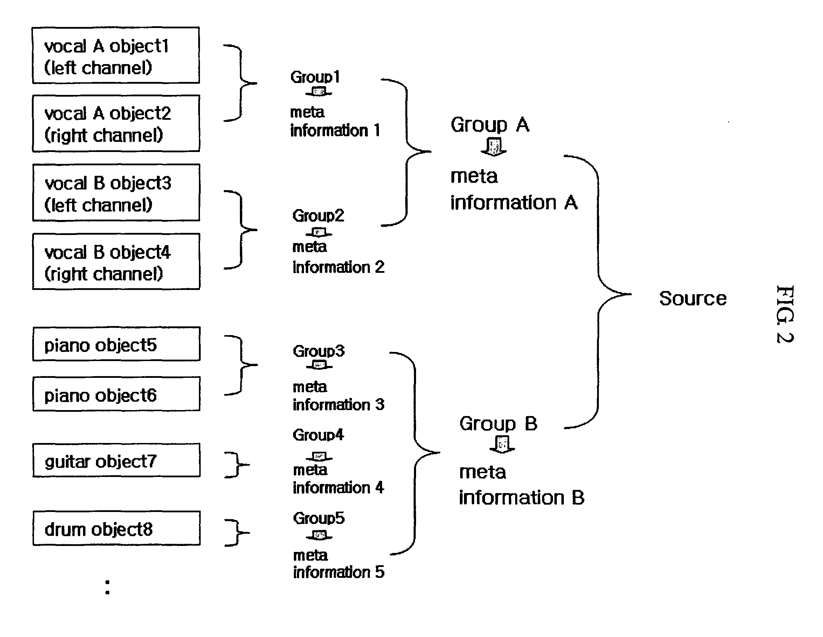

A method of transmitting meta information of the object information (OI) and a structure of a bit stream of an audio signal containing the meta information will be explained in detail with reference to FIGs. 2 to 6.

Meanwhile, the mix information (MXI) is the information generated based on object position information, object gain information, playback configuration information and the like. In particular, the object position information is the information inputted by a user to control a position or panning of each object. And, the object gain information is the information inputted by a user to control a gain of each object. The playback configuration information is the information containing the number of speakers, a position of a speaker, ambient information (virtual position of speaker) and the like. The playback configuration information may be inputted by a user, stored in previous or received from another device.

The downmix processing unit 120 receives downmix information (hereinafter named a downmix signal (DMX)) and then processes the downmix signal (DMX) using downmix processing information (DPI). And, it is able to process the downmix signal (DMX) to control a panning or gain of object.

The multi-channel decoder 130 receives the processed downmix and is able to generate a multi-channel signal by upmixing the processed downmix signal using multi-channel information (MI).

A method of transmitting meta information of the object information (OI) and a structure of a bit stream of an audio signal containing the meta information are explained in detail as follows.

FIG. 2 is a diagram of a method of transmitting meta information on an object according to an embodiment of the present invention.

In object-based audio coding, meta information on object can be transmitted and received. For instance, in the course of downmixing a plurality of objects into mono or stereo signal, meta information can be extracted from each object signal. And, the meta information can be controlled by a selection made by a user.

In this case, the meta information may mean meta-data. The meta-data is the data about data and may mean the data that describes attribute of information resource. Namely, the meta-data is not the data (e.g., video, audio, etc.) to be actually stored but means the data that provides information directly or indirectly associated with the data. If such meta-data is used, it is able to verify whether it is the data specified by a user and search for specific data easily and quickly. In particular, management facilitation is secured in aspect of possessing data or search facilitation is secured in aspect of using data.

In object-based audio coding, the meta information may mean the information that indicates attribute of object. For instance, the meta information can indicate whether one of a plurality of object signals constituting a sound source corresponds to a vocal object, a background object or the like. And, the meta information is able to indicate whether an object in the vocal object corresponds to an object for a left channel or an object for a right channel. Moreover, the meta information is able to indicate whether an object in the background object corresponds to a piano object, a drum object, a guitar object or one of other musical instrument objects.

Yet, in case of object signals having close correlation in-between, it is able to transmit meta information common to each object signal. So, if common information is transmitted once by grouping the object signals into one group, it is able to raise efficiency higher. For instance, assume that there are two vocal objects (left channel object and right channel object) obtained from stereo signal. In this case, the left channel object and the right channel object have the same attribute called 'vocal object'. And, the case of transmitting one common meta information only may be more efficient than the case of transmitting independent meta information per object. Hence, by grouping correlated object signals, it is able to transmit meta information on the grouped objects once only.

For instance, referring to FIG. 2, assume that there are vocal object A, vocal object B, piano object 5, piano object 6, guitar object 7 and drum object 8. The vocal object A may include a left channel object (vocal A object 1) and a right channel object (vocal A object 2). Likewise, the vocal object B can include a let channel object (vocal B object 3) and a right channel object (vocal B object 4).

In this case, it is able to group the correlated object signals. For instance, it is able to regard the left channel object (vocal A object 1) of the vocal object A and the right channel object (vocal A object 2) of the vocal object A as correlated objects. Hence, it is able to group them into a group (Group 1). Likewise, it is able to regard the left channel object (vocal B object 3) of the vocal object B and the right channel object (vocal B object 4) of the vocal object B as correlated objects. Hence, it is able to group them into a group (Group 2).

Moreover, since the piano object 5 and the piano object 6 have correlation in-between, it is able to group them into a group (Group 3). Thus, it is able to transmit meta information on the grouped objects (Group 1, Group2, Group 3) .

Moreover, a single object can be set to a single group as well as a plurality of objects. For instance, the guitar object (guitar object 7) can be set to a single group (Group 4), or the drum object (drum object 8) can be set to a single group (group 5).

Furthermore, the Group 1 and the Group 2 have close correlation as vocal object in-between. So, the Group 1 and the Group 2 can be grouped into another group (Group A). the piano objects (piano object 5, piano object 6), the guitar object (guitar object 7) and the drum object (drum object 8) have close correlation as background object or musical instrument object. Hence, it is able to group the Group 3, Group 4 and Group 5 into another group (group B). Thus, it is able to transmit meta information on the grouped objects (Group A, group B) once only. In this case, the Group 1 or the Group 2 can be regarded as a sort of subgroup for the Group A. And, the Group 3, the Group 4 or the Group 5 can be regarded as a sort of subgroup for the Group B.

According to another embodiment of the present invention, it is able to obtain sub-meta information on an object signal. In this case, the sub-meta information is able to indicate individual attribute of each of the grouped objects. For instance, in case of the vocal object, it is able to separately extract information indicating a left channel object and information indicating a right channel object. In particular, through the individual attribute information on the object, it is able to directly know whether currently extracted information is the information indicating the left channel object (vocal A object 1) of the vocal object A or the right channel object (vocal A object 2) of the vocal object A. And, the sub-meta information can be extracted from a header.

And, it is able to generate intrinsic meta information on each object using the meta information and the sub-meta information.

According to another embodiment, it is able to define detailed attribute information on an object signal using flag information. For instance, if flag information on a vocal object is 0, it means the left channel object of the vocal object. If flag information on a vocal object is 1, it may mean the right channel object. Alternatively, it is able to set the left channel object of the vocal object to a default value and next information can be set to the right channel object of the vocal object without separate information.

According to another embodiment of the present invention, it is able to utilize index information on an object together with meta information on the object. For instance, attribute information on an object is allocated by an index and then decided to be included in a table in advance. In this case, the object attribute information indicated by the index may mean meta information. And, the index information may be the information indicating a type of the object. It is able to assign attribute information (e.g., musical instrument name) on objects to 0~126 and '127' can be inputted as a text. For specific example, in case of a musical instrument object, information on an instrument name and an instrument player (e.g., guitar: Jimmy Page) can be transmitted as meta information. In this case, the instrument name is transmitted using index information according to a previously decided table and information on the instrument player can be transmitted as meta information.

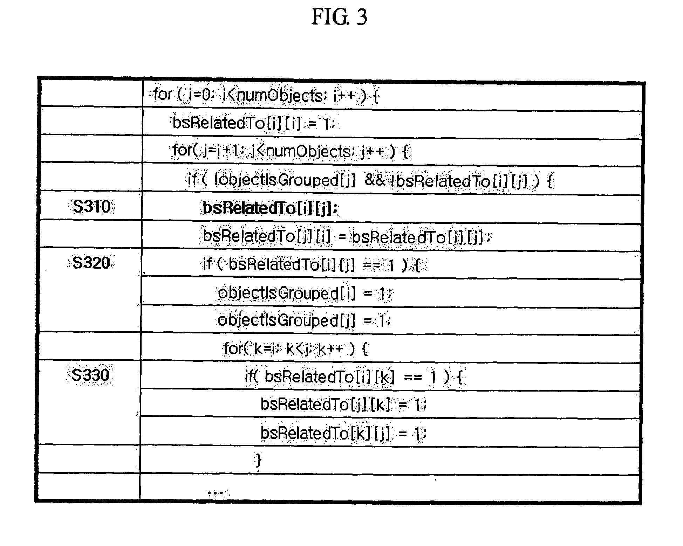

FIGs. 3 to 5 are diagrams of syntax for a method of obtaining information indicating correlation of grouped objects according to an embodiment of the present invention.

In processing an object-based audio signal, a single object constituting an input signal is processed as an independent object. For instance, in case that there is a stereo signal constituting a vocal, it can be processed by recognizing a left channel signal as a single object and a right channel signal as a single object. In case of constituting an object signal in the above manner, correlation may exist between objects having the same origin of signal. When coding is performed using the correlation, more efficient coding is possible. For instance, there can exist correlation between an object constituted with a left channel signal of a stereo signal constituting a vocal and an object constituted with a right channel signal thereof. And, information on the correlation is transmitted to be used.

Objects having the correlation are grouped and information common to the grouped objects is then transmitted once only. Hence, more efficient coding is possible.

According to an embodiment of the present invention, after correlated objects are grouped, it is necessary to define the syntax for transmitting information on the correlation. For instance, it is able to define the syntax shown in FIG. 3.

Referring to FIG. 3, the bold style may mean the information transmitted from a bit stream [S310]. In this case, when a single object is a part of stereo or multi-channel object, 'bsRelatedTo' may be the information that indicates whether other objects are parts of the same stereo or multi-channel object. The bsRelatedTo enables 1-bit information to be obtained from a bit stream. For instance, if bsRelatedTo[i] [j]=1, it may mean that an object i and an object j correspond to channels of the same stereo or multi-channel object.

It is able to check whether objects constitute a group based on a value of the bsRelatedTo [S320]. By checking the bsRelatedTo value for each object, it is able to check information on the correlation between objects [S330]. Thus, by transmitting the same information (e.g., meta information) for the grouped objects having the correlation in-between once only, more efficient coding is enabled.

The operational principle of the syntax shown in FIG. 3 is explained as follows. For instance, assume that there are seven objects, assume that objects 3 and 4 of the seven objects are correlated with each other, and assume that objects 5 and 6 of the seven objects are correlated with each other. Namely, each of the objects 1, 2 and 7 can be regarded as an object of a mono signal. And, the objects 3 and 4 or the objects 5 and 6 can be regarded as an object of a stereo signal. If so, a bit stream inputted by pseudo-code can be represented as the following 21 bits.
[0 0 0 0 0 0 0 0 0 0 0 1 0 0 0 0 0 0 1 0 0]

For another instance, assume that there are seven objects, that objects 1, 3 and 5 of the seven objects are correlated with each other, and that objects 2 and 6 of the seven objects are correlated with each other. Namely, each of the objects 4 and 7 can be regarded as an object of a mono signal. And, the objects 1, 3 and 5 or the objects 2 and 6 can be regarded as an object of a multi-channel signal. If so, a bit stream inputted by pseudo-code can be represented as the following 14 bits.

[0 1 0 1 0 0 0 1 0 0 0 0 0 0]

This is represented by the principle shown in Table 1.

[Table 1]

|      | obi1 | obj2 | obj3 | obj4 | obj5 | obj6 | obj7 |
|------|------|------|------|------|------|------|------|
| Obj1 | NA   | 0    | 1    | 0    | 1    | 0    | 0    |
| Obj2 | NA   | NA   | NA   | 0    | NA   | 1    | 0    |
| Obj3 | NA   | NA   | NA   | 0    | NA   | NA   | 0    |
| Obj4 | NA   | NA   | NA   | NA   | NA   | NA   | 0    |
| Obj5 | NA   | NA   | NA   | NA   | NA   | NA   | 0    |
| Obj6 | NA   | NA   | NA   | NA   | NA   | NA   | 0    |
| Obj7 | NA   | NA   | NA   | NA   | NA   | NA   | NA   |

In Table 1, 'NA' means that information is not transmitted and '0' or '1' may mean type of the information. A value of 1 is transmitted to correlated objects. So, 'bsRelatedTo' by this can be configured as Table 2.

[Table 2]

|      | obj1 | obj2 | obj3 | obj4 | obj5 | obj6 | obj7 |
|------|------|------|------|------|------|------|------|
| Obj1 | 1    | 0    | 1    | 0    | 1    | 0    | 0    |
| Oj2  | 0    | 1    | 0    | 0    | 0    | 1    | 0    |
| Obj3 | 1    | 0    | 1    | 0    | 1    | 0    | 0    |
| Obj4 | 0    | 0    | 0    | 1    | 0    | 0    | 0    |
| Obj5 | 1    | 0    | 1    | 0    | 1    | 0    | 0    |
| Obj6 | 0    | 1    | 0    | 0    | 0    | 1    | 0    |
| Obj7 | 0    | 0    | 0    | 0    | 0    | 0    | 1    |

Referring to Table 2, since the objects 1, 3 and 5 have correlation in-between, a value of 1 is transmitted and the objects 2, 4, 6 and 7 having no correlation with the object 1 do not have correlation with the object 3 or 5. Likewise, correlation information on the object 1 is naturally identical to that of the object 3 or 5. Hence, it is not necessary to transmit the same information on the objects having the correlation with the object 1. Likewise, it is not necessary to transmit information on the object 6 having the correlation with the object 2. Based on this, a bit stream inputted by pseudo-code can be represented as the following 10 bits.

[0 1 0 1 0 0 0 1 0 0]

This bit stream can be interpreted as Table 3.

[Table 3]

|      | obj1 | obj2 | obj3 | obj4 | obj5 | obj6 | Obj7 |
|------|------|------|------|------|------|------|------|
| Obj1 | NA   | 0    | 1    | 0    | 1    | 0    | 0    |
| Obj2 | NA   | NA   | NA   | 0    | NA   | 1    | 0    |
| Obj3 | NA   | NA   | NA   | NA   | NA   | NA   | NA   |
| Obj4 | NA   | NA   | NA   | NA   | NA   | NA   | 0    |
| Obj5 | NA   | NA   | NA   | NA   | NA   | NA   | NA   |

(continued)

|      | obj1 | obj2 | obj3 | obj4 | obj5 | obj6 | Obj7 |
|------|------|------|------|------|------|------|------|
| Obj6 | NA   | NA   | NA   | NA   | NA   | NA   | NA   |
| Obj7 | NA   | NA   | NA   | NA   | NA   | NA   | NA   |

Hence, it is able to configure 'bsRelatedTo' by the same scheme using the bit stream transmitted via Table 3.

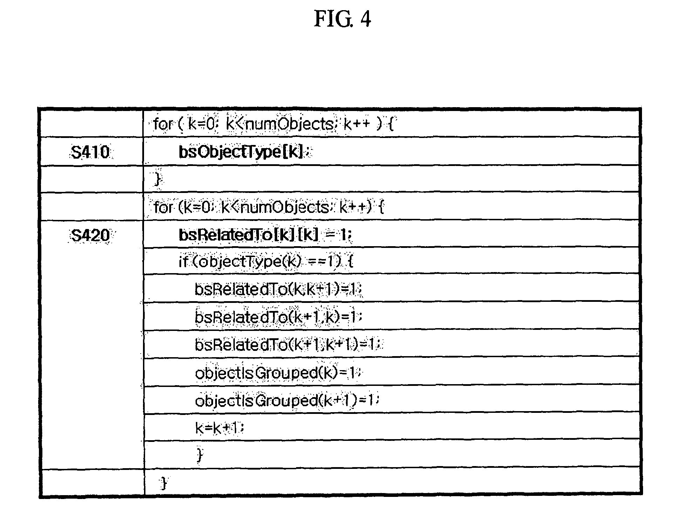

According to another embodiment of the present invention, it is able to define the syntax for indicating a correlation between objects for a random object [S410]. For instance, referring to FIG. 4, it is able to define 1-bit bsObjectType to indicate the correlation between objects. If bsObjectType = 0, it may mean an object of a mono signal. If bsObjectType = 1, it may mean an object of a stereo signal. Thus, if bsObjectType = 1, it is able to check information on correlation between objects based on a value of the bsObjectType. And, it is also able to check whether the respective objects constitute a group [S420].

Likewise, a bold style shown in FIG. 4 may mean the information transmitted from a bit stream. The operational principle of the syntax shown in FIG. 4 is explained as follows. For instance, assume that there are seven objects, in which objects 3 and 4 are correlated with each other and in which objects 5 and 6 are correlated with each other. Namely, since objects 1, 2 and 7 can be regarded as an object of a mono signal, a value of the bsObjectType is 0. Since objects 3 and 4 or objects 5 and 6 can be regarded as an object of a stereo signal, it results in bsObjectType = 1. Hence, an input stream inputted by pseudo-code can be represented as the following seven bits.
[0 0 1 1 1 1 0]

In the above embodiment, the following assumption may be necessary. For instance, correlated objects can be transmitted by being adjacent to each other. And, the correlation between objects can exist between objects taking each channel signal of a stereo signal only.

According to another embodiment of the present invention, in case of stereo signal, a predetermined bit number is allocated to a first channel and a bit number may not be allocated to the rest channel. For instance, in the above example, it is able to reduce a size of bit stream by allocating 0 bit in case of a mono signal, 1 bit to a first channel in case of a stereo signal and 0 bit to the rest channel of the stereo signal. So, a bit stream inputted by pseudo-code can be represented as the following 5 bits.
[0 0 1 1 0]

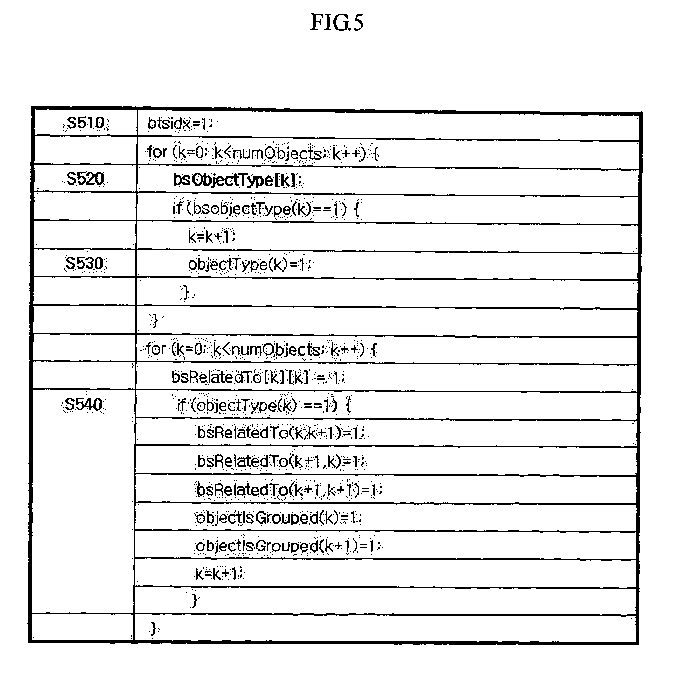

The above embodiment is able to define the syntax shown in FIG. 5.

In the embodiment of FIG. 5, if '1' is firstly extracted from a bit stream [S510], the corresponding object may mean a left channel signal of stereo signal. If '1' is extracted subsequently, it may mean a right channel signal of the stereo signal. In the embodiment of FIG. 5, if '1' is firstly extracted from a bit stream [S510], the corresponding object may mean a left channel signal of a stereo signal. And, the next may mean a right channel signal of the stereo signal without extracting another flag information.

As mentioned in the foregoing description of FIG. 4, it is able to define 1-bit bsObjectType to indicate a correlation between objects [S520]. If bsObjectType = 0, it means that a current object is the object of a mono signal. If bsObjectType = 1, it may mean that a current object is the object of a stereo signal. If the bsObjectType is 1, it is able to check a type (objectType) of each object [S530]. Thus, if objectType = 1, it is able to check information on correlation between objects based on a value of the bsRelatedTo. And, it is also able to check whether the respective objects constitute a group [S540].

According to another embodiment of the present invention, a method of utilizing information of an original channel for an object obtained from a stereo signal is proposed.

In object-based audio coding, information on an object is transmitted and then utilized for decoding. The object information can include object level information, object correlation information, object gain information and the like. In this case, the object gain information is the information inputted by a user to control a gain of each object. In particular, the object gain information indicates how a specific object is contained in a downmix signal and can be represented as Formula 1.

$$[\text{Formula 1}]$$

$$x\_1 = \text{sum} (a\_i * s\_i)$$

$$x\_2 = \text{sum} (b\_i * s\_i)$$

In Formula 1, x_1 and x_2 are downmix signals. For instance, x_1 means a left channel signal of a downmix signal and x_2 may mean a right channel signal of the downmix signal. s_i means an $i^{th}$ object signal, a_i means object gain information indicating a gain included in a left channel of the $i^{th}$ object signal, and b_i may mean object gain information indicating a gain included in a right channel of the $i^{th}$ object signal.

The object gain information can be contained in a bit stream in various ways. For instance, there is a method that a_i and b_i can be directly included in the bit stream. Alternatively, there is a method that a ratio of a_i to b_i and either a_i or b_i can be included. Alternatively, there is a method that a ratio of a_i to b_i and an energy sum of a_i and b_i can be included.

If s_i is an object signal constituted with a signal of a specific channel in a stereo signal, it is able to assume that the object signal is included in the channel only in rendering a downmix signal. Namely, if the s_i is the object constituted with the left channel signal of the stereo signal, it is able to assume that the b_i is always 0. Likewise, if s_j is the object constituted with the right channel signal of the stereo signal, it can be observed that a_j is always 0.

In the present invention, in case that an object signal is an object of a stereo signal, it is able to reduce a transmit amount of object gain information according to a channel to which the object signal corresponds. Using the embodiments shown in Table 2 and Table 3, it is able to know a channel corresponding to the object signal if the object signal is an object of a stereo signal. If so, it is able to further reduce a bit rate.

A decoder determines whether there is channel information in each object signal using the transmitted bsObjectType value. If the object signal is an object of a stereo signal, the decoder is able to receive only one value of object gain information. In case of the object signal is an object of the stereo signal, if the object signal is continuously processed by encoder, it is able to configure and transmit the object gain information as follows. For instance, it is able to transmit a_i and b_i+1. In this case, it is able to obtain a_i and b_i+1 from the transmitted object gain information. And, it is able to reduce a bit rate by b_1=a_i+1=0.

In object-based audio coding, it is able to configure an object signal using a multi-channel signal. For instance, a multi-channel signal is rendered into a stereo downmix signal using MPEG Surround encoder. It is then able to generate the object signal using the stereo downmix signal. The aforesaid embodiments are applicable in the same manner. And, the same principle is applicable to a case of using a multi-channel downmix signal in object-based audio coding as well.

Structure of the object-based bit stream is explained in detail as follows.

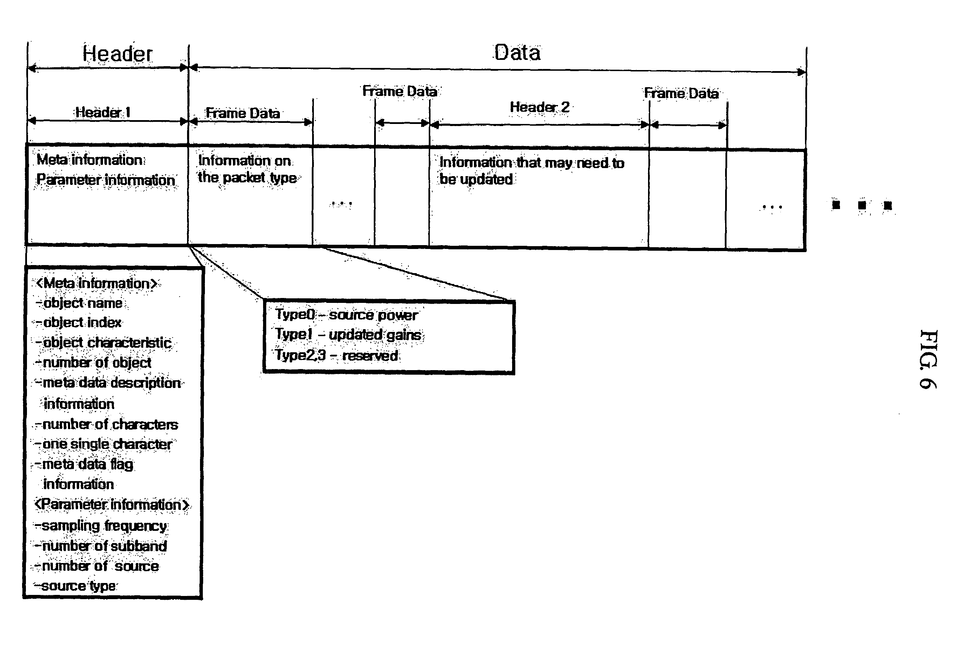

FIG. 6 is a structural diagram of a bit stream containing meta information on object according to an embodiment of the present invention.

Bit stream may mean a bundle of parameters or data or a general bit stream in a compressed type for transmission or storage. Moreover, bit stream can be interpreted in a wider meaning to indicate a type of parameter before the representation as bit stream. A decoding device is able to obtain object information from the object-based bit stream. Information contained in the object-based bit stream is explained in the following description.

Referring to FIG. 6, an object-based bit stream can include a header and data. The header (Header 1) can include meta information, parameter information and the like. And, the meta information can contain the following information. For instance, the meta information can contain object name (object name), an index indicating an object (object index), detailed attribute information on an object (object characteristic), information on the number of objects (number of object), description information on meta information (meta-data description information), information on the number of characters of meta-data (number of characters), character information of meta-data (one single character), meta-data flag information (meta-data flag information) and the like.

In this case, the object name (object name) may mean information indicating attribute of such an object as a vocal object, a musical instrument object, a guitar object, a piano object and the like. The index indicating an object (object index) may mean information for assigning an index to attribute information. For instance, by assigning an index to each musical instrument name, it is able to determine a table in advance. The detailed attribute information on an object (object characteristic) may mean individual attribute information of a lower object. In this case, when similar objects are grouped into a single group object, the lower object may mean each of the similar objects. For instance, in case of a vocal object, there are information indicating a left channel object and information indicating a right channel object.

The information on the number of objects (number of object) may mean the number of objects when object-based audio signal parameters are transmitted. The description information on meta information (meta-data description information) may mean description information on meta data for an encoded object. The information on the number of characters of meta-data (number of characters) may mean the number of characters used for meta-data description of a single object. The character information of meta-data (one single character) may mean each character of meta-data of a single object. And, the meta-data flag information (meta-data flag information) may mean a flag indicating whether meta-data information of encoded objects will be transmitted.

Meanwhile, the parameter information can include a sampling frequency, the number of subbands, the number of source signals, a source type and the like. Optionally, the parameter information can include playback configuration information of a source signal and the like.

The data can include at least one frame data (Frame Data). If necessary, a header (Header 2) can be included together with the frame data. In this case, the Header 2 can contain informations that may need to be updated.

The frame data can include information on a data type included in each frame. For instance, in case of a first data type (Type0), the frame data can include minimum information. For detailed example, the first data type (Type0) can include a source power associated with side information. In case of a second data type (Type1), the frame data can include gains that are additionally updated. In case of third and fourth data types, the frame data can be allocated as a reserved area for a future use. If the bit stream is used for a broadcast, the reserved area can include information (e.g., sampling frequency, number of subbands, etc.) necessary to match a tuning of a broadcast signal.

As mentioned in the foregoing description, the signal processing apparatus according to the present invention, which is provided to such a transmitting/receiving device for such multimedia broadcasting as DMB (digital multimedia broadcasting), is usable to decode audio signals, data signals and the like. And, the multimedia broadcast transmitting/ receiving device can include a mobile communication terminal.

Besides, the above-described signal processing method according to the present invention can be implemented in a program recorded medium as computer-readable codes. The computer-readable media include all kinds of recording devices in which data readable by a computer system are stored. The computer-readable media include ROM, RAM, CD-ROAM, magnetic tapes, floppy discs, optical data storage devices, and the like for example and also include carrier-wave type implementations (e.g., transmission via Internet). And, the bit stream generated by the signal processing method is stored in a computer-readable recording medium or can be transmitted via wire/wireless communication network.

<u>INDUSTRIAL APPLICABILITY</u>

While the present invention has been described and illustrated herein with reference to the preferred embodiments thereof, it will be apparent to those skilled in the art that various modifications and variations can be made therein without departing from the scope of the invention. Thus, it is intended that the present invention covers the modifications and variations of this invention that come within the scope of the appended claims and their equivalents.

**Claims**

1. A method of processing an audio signal, comprising:

   receiving a downmix signal including at least one object, and a bitstream including object information;
   obtaining correlation information indicating whether an object is grouped with other object from the bitstream;
   obtaining one meta information common to grouped objects based on the correlation information;
   receiving mix information; and
   generating at least one of downmix processing information and multi-channel information based on the object information and the mix information,
   wherein the object information includes at least one of object level information, object correlation information and object gain information.

2. The method of claim 1, further comprising obtaining sub-meta information on at least one object of the grouped objects, wherein the sub-meta information indicates individual attribute of each of the grouped objects.

3. The method of claim 1, further comprising:

   processing the downmix signal using the downmix processing information; and
   generating a multi-channel signal based on the processed downmix signal and the multi-channel information.

4. The method of claim 2, further comprising obtaining flag information indicating whether to obtain the sub-meta information, wherein the sub-meta information is obtained based on the flag information.

5. The method of claim 1, further comprising obtaining identification information indicating sub-meta information on at least one object of the grouped objects, wherein the sub-meta information of the grouped objects is checked based on the identification information.

6. The method of claim 1, further comprising obtaining index information indicating a type of each of the grouped objects, wherein the meta information is obtained based on the index information.

7. The method of claim 1, wherein when the grouped objects include an object indicating a left channel and an object indicating a right channel, the meta information of the object indicating the left channel is obtained only.

8.  The method of claim 1, further comprising obtaining flag information indicating whether the meta information was transmitted, wherein the meta information is obtained based on the flag information.

9.  The method of claim 1, wherein the meta information includes a character number of meta-data and each character information of the meta-data.

10. The method of claim 1, wherein the downmix signal is received as a broadcast signal.

11. The method of claim 1, wherein the downmix signal is received via digital medium.

12. A computer-readable medium comprising a program recorded thereon to execute the method described in claim 1.

13. An apparatus for processing an audio signal, comprising:

 a receiving unit (120) adapted to receive a downmix signal including at least one object, and a bitstream including object information;
 a first information generating unit (110) adapted to obtain correlation information indicating whether an object is grouped with other object from the bitstream, to receive mix information, and to generate at least one of downmix processing information and multi-channel information based on the object information and the mix information; and
 a second information generating unit (110) adapted to obtain one meta information common to grouped objects based on the correlation information,
 wherein the object information includes at least one of object level information, object correlation information and object gain information.


**Patentansprüche**

1.  Verfahren zur Verarbeitung eines Audiosignals, umfassend:

 Empfangen eines Downmix-Signals, das zumindest ein Objekt umfasst, und eines Bitstroms, der Objektinformationen umfasst;
 Erhalten von Korrelationsinformationen, die angeben, ob ein Objekt mit einem anderen Objekt aus dem Bitstrom gruppiert ist;
 Erhalten einer Metainformation, die gruppierten Objekten gemein ist, auf der Grundlage der Korrelationsinformationen;
 Empfangen von Mischinformationen; und
 Erzeugen zumindest einer Downmix-Verarbeitungsinformation und von Mehrfachkanalinformationen auf der Grundlage der Objektinformationen und der Mischinformationen,
 wobei die Objektinformationen zumindest eine von Objektpegelinformationen, Objektkorrelationsinformationen und Objektverstärkungsinformationen umfassen.

2.  Verfahren gemäß Anspruch 1, weiterhin umfassend Erhalten von Untermetainformationen bezüglich zumindest eines Objekts der gruppierten Objekte, wobei die Untermetainformationen individuelle Attribute von jedem der gruppierten Objekte angeben.

3.  Verfahren gemäß Anspruch 1, weiterhin umfassend:

 Erhalten des Downmix-Signals unter Verwendung der Downmix-Verarbeitungsinformationen; und
 Erzeugen eines Mehrfachkanalsignals auf der Grundlage des verarbeiteten Downmix-Signals und der Mehrfachkanalinformationen.

4.  Verfahren gemäß Anspruch 2, weiterhin umfassend Erhalten von Flaggeninformationen, die angeben, ob Untermetainformationen zu erhalten sind, wobei die Untermetainformationen auf der Grundlage der Flaggeninformationen erhalten werden.

**5.** Verfahren gemäß Anspruch 1, weiterhin umfassend Erhalten von Identifizierungsinformationen, die Untermetainformationen bezüglich zumindest eines Objekts der gruppierten Objekte angeben, wobei die Untermetainformationen der gruppierten Objekte auf der Grundlage der Identifizierungsinformationen geprüft werden.

**6.** Verfahren gemäß Anspruch 1, weiterhin umfassend Erhalten von Indexinformationen, die einen Typ jedes der gruppierten Objekte angeben, wobei die Metainformationen auf der Grundlage der Indexinformationen erhalten werden.

**7.** Verfahren gemäß Anspruch 1, wobei, wenn die gruppierten Objekte ein einen linken Kanal angebendes Objekt und ein einen rechten Kanal angebendes Objekt umfassen, lediglich die Metainformationen des den linken Kanal angebenden Objekts erhalten werden.

**8.** Verfahren gemäß Anspruch 1, weiterhin umfassend Erhalten von Flaggeninformationen, die angeben, ob die Metainformationen übertragen wurden, wobei die Metainformationen auf der Grundlage der Flaggeninformationen erhalten werden.

**9.** Verfahren gemäß Anspruch 1, wobei die Metainformationen eine Zeichenzahl von Metadaten und jede Zeicheninformation der Metadaten umfassen.

**10.** Verfahren gemäß Anspruch 1, wobei das Downmix-Signal als ein Rundsendungssignal empfangen wird.

**11.** Verfahren gemäß Anspruch 1, wobei das Downmix-Signal über ein digitales Medium empfangen wird.

**12.** Computerlesbares Medium, umfassend ein auf ihm aufgezeichnetes Programm zum Ausführen des in Anspruch 1 beschriebenen Verfahrens.

**13.** Vorrichtung zur Verarbeitung eines Audiosignals, umfassend:

eine Empfangseinheit (120), die eingerichtet ist, um ein Downmix-Signal, das zumindest ein Objekt umfasst, und einen Bitstrom, der Objektinformationen umfasst, zu empfangen;
eine erste Informationserzeugungseinheit (110), die eigerichtet ist, um Korrelationsinformationen zu erhalten, die angeben, ob ein Objekt mit einem anderen Objekt aus dem Bitstrom gruppiert ist, um Mischinformationen zu empfangen, und um zumindest eine Downmix-Verarbeitungsinformation und Mehrfachkanalinformationen auf der Grundlage der Objektinformationen und der Mischinformationen zu erzeugen; und
eine zweite Innformationserzeugungseinheit (110), die eingerichtet ist, um eine Metainformation, die gruppierten Objekten gemein ist, auf der Grundlage der Korrelationsinformationen zu erhalten, wobei die Objektinformationen zumindest eine von Objektpegelinformationen, Objektkorrelationsinformationen und Objektverstärkungsinformationen umfassen.

**Revendications**

**1.** Procédé de traitement d'un signal audio, comprenant :

la réception d'un signal à mixage réducteur incluant au moins un objet, et un train de bits incluant une information d'objet ;
l'obtention d'une information de corrélation indiquant si un objet est groupé avec un autre objet à partir du train de bits ;
l'obtention d'une méta-information commune à des objets groupés sur la base de l'information de corrélation ;
la réception d'une information de mixage ; et
la génération d'au moins l'une d'une information de traitement de mixage réducteur et d'une information multicanal sur la base de l'information d'objet et de l'information de mixage,
dans lequel l'information d'objet inclut au moins l'une d'une information de niveau d'objet, d'une information de corrélation d'objet et d'une information de gain d'objet.

**2.** Procédé selon la revendication 1, comprenant en outre l'obtention d'une sous-méta-information sur au moins un objet des objets groupés, dans lequel la sous-méta-information indique un attribut individuel de chacun des objets groupés.

**3.** Procédé selon la revendication 1, comprenant en outre :

le traitement du signal à mixage réducteur en utilisant l'information de traitement de mixage réducteur ; et
la génération d'un signal multicanal sur la base du signal à mixage réducteur traité et de l'information multicanal.

**4.** Procédé selon la revendication 2, comprenant en outre l'obtention d'une information de drapeau indiquant s'il convient d'obtenir la sous-méta-information, dans lequel la sous-méta-information est obtenue sur la base de l'information de drapeau.

**5.** Procédé selon la revendication 1, comprenant en outre l'obtention d'une information d'identification indiquant une sous-méta-information sur au moins un objet parmi les objets groupés, dans lequel la sous-méta-information des objets groupés est contrôlée sur la base de l'information d'identification.

**6.** Procédé selon la revendication 1, comprenant en outre l'obtention d'une information d'index indiquant un type de chacun des objets groupés, dans lequel la méta-information est obtenue sur la base de l'information d'index.

**7.** Procédé selon la revendication 1, dans lequel les objets groupés incluent un objet indiquant un canal de gauche et un objet indiquant un canal de droite, la méta-information de l'objet indiquant que le canal de gauche est obtenu uniquement.

**8.** Procédé selon la revendication 1, comprenant en outre l'obtention d'une information de drapeau indiquant si la méta-information a été transmise, dans lequel la méta-information est obtenue sur la base de l'information de drapeau.

**9.** Procédé selon la revendication 1, dans lequel la méta-information inclut un nombre de caractères de métadonnées et chaque information de caractère des métadonnées.

**10.** Procédé selon la revendication 1, dans lequel le signal à mixage réducteur est reçu sous la forme d'un signal de diffusion.

**11.** Procédé selon la revendication 1, dans lequel le signal à mixage réducteur est reçu par l'intermédiaire d'un support numérique.

**12.** Support lisible par un ordinateur comprenant un programme enregistré sur celui-ci pour exécuter le procédé selon la revendication 1.

**13.** Appareil pour traiter un signal audio, comprenant :

une unité de réception (120) adaptée à recevoir un signal à mixage réducteur incluant au moins un objet, et un train de bits incluant une information d'objet ;
une première unité de génération d'information (110) adaptée à obtenir une information de corrélation indiquant si un objet est groupé avec un autre objet à partir du train de bits, à recevoir une information de mixage, et à générer au moins l'une d'une information de traitement de mixage réducteur et d'une information multicanal sur la base de l'information d'objet et de l'information de mixage ; et
une deuxième unité de génération d'information (110) adaptée à obtenir une méta-information commune à des objets groupés sur la base de l'information de corrélation,
dans lequel l'information d'objet inclut au moins l'une d'une information de niveau d'objet, d'une information de corrélation d'objet et d'une information de gain d'objet.

FIG. 1

100

# FIG. 2

FIG. 3

```
for ( i=0; i<numObjects; i++ ) {
    bsRelatedTo[i][i] = 1;
    for( j=i+1; j<numObjects; j++ ) {
        if ( !objectIsGrouped[j] && !bsRelatedTo[i][j] ) {
            bsRelatedTo[i][j];
            bsRelatedTo[j][i] = bsRelatedTo[i][j];
            if ( bsRelatedTo[i][j] == 1 ) {
                objectIsGrouped[i] = 1;
                objectIsGrouped[j] = 1;
                for( k=i; k<j; k++ ) {
                    if( bsRelatedTo[i][k] == 1 ) {
                        bsRelatedTo[j][k] = 1;
                        bsRelatedTo[k][j] = 1;
                    }
                    ....
```

| S310 | |
| S320 | |
| S330 | |

FIG. 4

| | |
|---|---|
| | for ( k=0; k<numObjects; k++ ) { |
| S410 | bsObjectType[k]; |
| | } |
| | for (k=0; k<numObjects; k++) { |
| S420 | bsRelatedTo[k][k] = 1; |
| | if (objectType(k) ==1) { |
| | bsRelatedTo(k,k+1)=1; |
| | bsRelatedTo(k+1,k)=1; |
| | bsRelatedTo(k+1,k+1)=1; |
| | objectIsGrouped(k)=1; |
| | objectIsGrouped(k+1)=1; |
| | k=k+1; |
| | } |
| | } |

# FIG.5

| S510 | btsidx=1; |
| --- | --- |
| | for (k=0; k<numObjects; k++) { |
| S520 | **bsObjectType[k];** |
| | if (bsobjectType(k)==1) { |
| | k=k+1; |
| S530 | objectType(k)=1; |
| | } |
| | } |
| | for (k=0; k<numObjects; k++) { |
| | bsRelatedTo[k][k] = 1; |
| S540 | if (objectType(k) ==1) { |
| | bsRelatedTo(k,k+1)=1; |
| | bsRelatedTo(k+1,k)=1; |
| | bsRelatedTo(k+1,k+1)=1; |
| | objectIsGrouped(k)=1; |
| | objectIsGrouped(k+1)=1; |
| | k=k+1; |
| | } |
| | } |

EP 2 137 726 B1

| Header | Data | | | | | |
|---|---|---|---|---|---|---|
| Header 1 | Frame Data | | Frame Data | Header 2 | Frame Data | |
| Meta information Parameter information | Information on the packet type | ... | | Information that may need to be updated | | ... |

```
<Meta information>
-object name
-object index
-object characteristic
-number of object
-meta data description
 information
-number of characters
-one single character
-meta data flag
 information
<Parameter information>
-sampling frequency
-number of subband
-number of source
-source type
```

```
Type0 – source power
Type1 – updated gains
Type2,3 – reserved
```

FIG. 6

**EP 2 137 726 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2008046531 A1